(19) Europäisches Patentamt
European Patent Office
Office européen des brevets

(11) **EP 3 480 617 A1**

(12) **EUROPEAN PATENT APPLICATION**

(43) Date of publication:
**08.05.2019 Bulletin 2019/19**

(51) Int Cl.:
**G01R 33/561** *(2006.01)*  **G01R 33/563** *(2006.01)*
**G01R 33/565** *(2006.01)*  **G01R 33/567** *(2006.01)*

(21) Application number: **17199993.1**

(22) Date of filing: **03.11.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Koninklijke Philips N.V.**
**5656 AE Eindhoven (NL)**

(72) Inventors:
• **KARAMPINOS, Dimitrios**
**5656 AE Eindhoven (NL)**

• **CERVANTES, Barbara**
**5656 AE Eindhoven (NL)**
• **VAN TU, Anh**
**5656 AE Eindhoven (NL)**
• **KOOIJMAN-KURFUERST, Hendrik**
**5656 AE Eindhoven (NL)**

(74) Representative: **de Haan, Poul Erik et al**
**Philips International B.V.**
**Philips Intellectual Property & Standards**
**High Tech Campus 5**
**5656 AE Eindhoven (NL)**

(54) **DIFFUSION WEIGHTED TURBO SPIN ECHO MR IMAGING WITH MOTION COMPENSATION**

(57) The invention relates to a method of MR imaging of an object (10) placed in an examination volume of a MR apparatus (1). It is an object of the invention to enable motion-resistant multi-shot diffusion-weighted turbo spin echo imaging with efficient image acquisition and reconstruction. The method of the invention comprises the steps of:
subjecting the object (10) to a number of shots of a diffusion-weighted turbo spin echo imaging sequence, a train of echo signals being generated by each shot, wherein the train of echo signals comprises a number of start-up echo signals (NAV) and a number of imaging echo signals (SE) generated temporally subsequent to the start-up echo signals (NAV);
acquiring the start-up echo signals (NAV);
acquiring the imaging echo signals (SE);
deriving motion-induced phase errors from the start-up echo signals (NAV);
and reconstructing a diffusion weighted MR image from the imaging echo signals (SE), wherein a motion-compensation is applied by phase-correcting the MR image according to the motion-induced phase errors. Moreover, the invention relates to an MR apparatus (1) for carrying out this method as well as to a computer program to be run on an MR apparatus (1).

Fig. 2

**Description**

FIELD OF THE INVENTION

The invention relates to the field of magnetic resonance (MR) imaging. It concerns a method of MR imaging of an object. The invention also relates to an MR apparatus and to a computer program to be run on an MR apparatus.

BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for imaging of soft tissue they are superior to other imaging methods in many respects, do not require ionizing radiation and are usually not invasive.

According to the MR method in general, the object, for example the body of the patient to be examined, is arranged in a strong, uniform magnetic field whose direction at the same time defines an axis (normally the z-axis) of the co-ordinate system on which the measurement is based. The magnetic field produces different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse), so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the spins are deflected from the z axis to the transverse plane (flip angle 90°).

After termination of the RF pulse, the magnetization relaxes back to the original state of equilibrium, in which the magnetization in the z direction is built up again with a first time constant $T_1$ (spin lattice or longitudinal relaxation time), and the magnetization in the direction perpendicular to the z direction relaxes with a second time constant $T_2$ (spin-spin or transverse relaxation time). The variation of the magnetization can be detected by means of receiving RF coils which are arranged and oriented within an examination volume of the MR apparatus in such a manner that the variation of the magnetization is measured in the direction perpendicular to the z-axis. The decay of the transverse magnetization is accompanied, after application of, for example, a 90° pulse, by a transition of the nuclear spins (induced by local magnetic field inhomogeneities) from an ordered state with the same phase to a state in which all phase angles are uniformly distributed (dephasing). The dephasing can be compensated by means of a refocusing RF pulse (for example a 180° pulse). This produces an echo signal (spin echo) in the receiving coils.

To realize spatial resolution in the body, constant magnetic field gradients extending along the three main axes are superposed on the uniform magnetic field, leading to a linear spatial dependency of the spin resonance frequency. The signal picked up in the RF receiving coils then contains components of different frequencies which can be associated with different locations in the body. The signal data obtained via the RF receiving coils corresponds to the spatial frequency domain and is called k-space data. The k-space data usually includes multiple lines acquired with different phase encoding. Each line is digitized by collecting a number of samples. A set of k-space data is converted to a MR image by means of an image reconstruction algorithm.

MR imaging is sensitive to diffusion. Known diffusion weighted imaging (DWI) techniques are commonly performed by using imaging sequences comprising diffusion gradients, wherein the diffusion of protons (of water molecules) along the direction of the diffusion gradient reduces the amplitude of the acquired MR signals. Diffusion tensor imaging (DTI) is a more sophisticated form of DWI, which allows for the determination of both the magnitude and the directionality of diffusion. For example, DTI enables to visualize white matter fibers in MR brain imaging and can map subtle changes in the white matter associated with diseases like brain infarction, multiple sclerosis, epilepsy etc.

DWI/DTI techniques are particularly vulnerable to macroscopic patient motion, as the signal attenuation resulting from the motion in the presence of the diffusion gradients can confound the measurement of interest. Subject motion during an MR examination can be particularly problematic in populations like children, the elderly, or patients with medical conditions that prevent them from lying still, such as Parkinson's disease. Further undesired types of motion include, but are not limited to: scanner vibration, cardiac pulsation, and respiration. Motion affects the data by shifts of the imaged tissue resulting in ghosting artifacts in the reconstructed MR images.

When an imaged object moves in the presence of a diffusion gradient, the transverse magnetization component of its spins accumulates a phase. In most cases, the undesired motion is spatially smooth and the accumulated phase is uniform for all spins within a given image voxel. As a result, the diffusion-weighted signal attributed to the voxel is contaminated with an additional phase, referred to herein as the motion-induced phase error, as compared to the case in which the portion of the object where the voxel is located is stationary.

When multiple shots of a diffusion-weighted imaging sequence are needed to reconstruct a single diffusion-weighted MR image, the motion-induced inter-shot phase errors result in corrupted diffusion-weighted MR images and incorrect diffusion parameter maps. Hence, to avoid significant artifacts resulting from motion, DWI data have commonly been acquired using single-shot imaging sequences, such as single-shot echo-planar imaging (EPI) or single-shot turbo spin echo (TSE) imaging. However, the image quality can be low and the spatial resolution is limited in single-shot DWI. As the spatial resolution increases in single-shot EPI, geometric distortion effects and chemical shift artifacts also increase, whereby the accuracy of diffusion parameter measurements is reduced. Single-shot TSE minimizes geometric distortions and chemical shift artifacts, which are essential especially in body regions with large Bo inhomogeneities. However, single-shot TSE is affected by increased blurring when increasing spatial resolution.

Recent efforts have been made to address the limitations of single-shot TSE DWI and increase the spatial resolution of single-shot TSE by employing multi-shot TSE. Multi-shot three-dimensional TSE DWI techniques have been proposed using motion-compensated diffusion preparation only in regions with limited susceptibility to motion (see Zhang et al., "Diffusion-prepared stimulated-echo turbo spin echo (DPsti-TSE): An eddy current-insensitive sequence for three-dimensional high-resolution and undistorted diffusion-weighted imaging", NMR in biomedicine 2017; Cervantes et al., "High-resolution DTI of distal peripheral nerves using flow-compensated diffusion-prepared 3D TSE", Proc. Intl. Soc. Mag. Reson. Med. 2016, 24:4530; Xie et al., "High resolution 3D diffusion cardiovascular magnetic resonance of carotid vessel wall to detect lipid core without contrast media", J. Cardiovasc. Magn. Reson. 2014, 16:67; Zhang et al., "High resolution 3D diffusion imaging of carotid vessel wall using stimulated echo based diffusion prepared turbo spin echo sequence", Proc. Intl. Soc. Mag. Reson. Med. 2016, 24:959). Using velocity-compensated diffusion preparation has been shown to produce diffusion parameters maps which are susceptible to motion-induced phase errors.

SUMMARY OF THE INVENTION

From the foregoing it is readily appreciated that there is a need for an improved TSE DWI technique. It is an object of the invention to enable motion-resistant TSE DWI with efficient image acquisition and reconstruction.

In accordance with the invention, a method of MR imaging of an object placed in an examination volume of a MR apparatus is disclosed. The method comprises the steps of: subjecting the object to a number of shots of a diffusion-weighted turbo spin echo imaging sequence, a train of echo signals being generated by each shot, wherein the train of echo signals comprises a number of start-up echo signals and a number of imaging echo signals generated temporally subsequent to the start-up echo signals;

acquiring the start-up echo signals;

acquiring the imaging echo signals;

deriving motion-induced phase errors from the start-up echo signals; and

reconstructing a diffusion weighted MR image from the imaging echo signals, wherein a motion-compensation is applied by phase-correcting the MR image according to the motion-induced phase errors.

The invention enables multi-shot DWI with shot-to-shot phase error navigation and correction and thereby provides a diffusion-weighted multi-shot turbo spin echo imaging technique as a powerful technique for high resolution and low distortion diffusion imaging that is of especially high demand in body applications.

According to the invention, the imaging sequence is a TSE sequence, each 'shot' of the imaging sequence comprising an RF pulse for excitation of transverse nuclear magnetization followed by a number of refocusing RF pulses generating a train of diffusion-encoded spin echo signals enabling a very efficient data acquisition. The DWI TSE imaging sequence of the invention may employ diffusion preparation for diffusion weighting. In this case, each shot of the TSE imaging sequence according to the invention comprises a diffusion preparation module (for example a stimulated echo sequence) and an RF pulse for excitation of transverse nuclear magnetization followed by a number of refocusing RF pulses generating a train of diffusion-encoded spin echo signals. These echo signals are acquired, wherein each imaging echo signal represents a k-space profile. A number of two or more of such shots are applied for completely sampling k-space in order to be able to reconstruct a full diffusion-weighted MR image from the acquired imaging echo signals. The multi-shot TSE imaging sequence is applied according to the invention to achieve high image quality and to measure diffusion properties at high precision.

The invention exploits the fact that there are a certain number of start-up echo signals in each shot of the TSE imaging sequence before the actual acquisition of the imaging data starts so as to allow the echo train to stabilize and to reach a steady state of the transverse nuclear magnetization. The invention uses the start-up echo signals to acquire a low-resolution navigator image for the estimation of the motion-induced phase errors that are later used in the reconstruction for motion-compensation in the high-resolution diffusion-weighted imaging data. In other words, the start-up echo signals offer the acquisition of 'free' navigators which does not lead to any increase in the turbo factor, the specific absorption rate (SAR), or the required scan time. This is the essential insight of the invention.

In a preferred embodiment of the invention, a two-dimensional slice of k-space is sampled by the number of shots of the imaging sequence. The invention further enables sampling of a three-dimensional volume of k-space in a number of shots of the imaging sequence. For example, a two-dimensional slice of k-space may be sampled by each shot of the imaging sequence, wherein the three-dimensional volume of k-space is composed of a number of such subsequently sampled parallel k-space slices.

In a further preferred embodiment of the invention, the motion-induced phase errors are derived by comparing start-up echo signals acquired with and without diffusion weighting. This means that the imaging sequence is executed once without diffusion weighting (i.e., with the b-value reflecting the strength and timing of the diffusion gradients being equal to zero). The phase map derived from the start-up echo signals without diffusion weighting is then used as a reference in order to estimate the phase errors as differences between the reference phase map and the phase maps derived from the start-up echo signals of the different diffusion-weighted shots of the imaging sequence.

The method of the invention described thus far can be carried out by means of a MR apparatus including at least one main magnet coil for generating a uniform static magnetic field within an examination volume, a number of gradient coils for generating switched magnetic field gradients in different spatial directions within the examination volume, at least one RF coil for generating RF pulses within the examination volume and/or for receiving MR signals from an object positioned in the examination volume, a control unit for controlling the temporal succession of RF pulses and switched magnetic field gradients, and a reconstruction unit. The method of the invention can be implemented, for example, by a corresponding programming of the reconstruction unit and/or the control unit of the MR apparatus.

The method of the invention can be advantageously carried out in most MR devices in clinical use at present. To this end it is merely necessary to utilize a computer program by which the MR apparatus is controlled such that it performs the above-explained method steps of the invention. The computer program may be present either on a data carrier or be present in a data network so as to be downloaded for installation in the control unit of the MR apparatus.

BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:

Fig. 1 shows a MR apparatus for carrying out the method of the invention;
Fig. 2 shows a diagram of an imaging sequence used in an embodiment of the invention;
Fig. 3 illustrates the method of the invention as a flow chart;
Fig. 4 shows diffusion-weighted MR images, ADC maps and FA maps reconstructed without and with motion-detection and -correction according to the invention.

DETAILED DESCRIPTION OF THE EMBODIMENTS

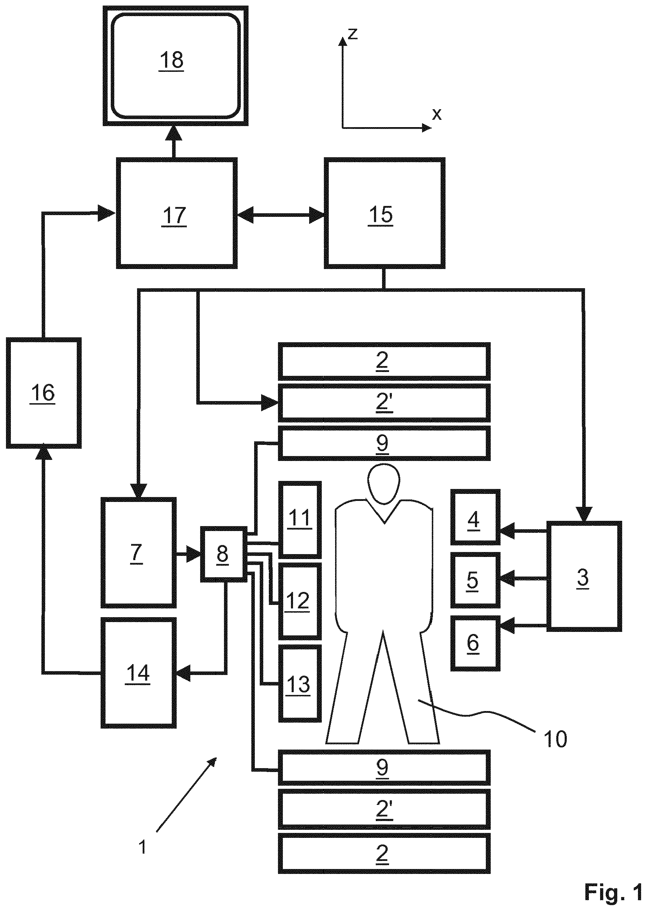

With reference to Fig. 1, a MR apparatus 1 is shown. The apparatus comprises superconducting or resistive main magnet coils 2 such that a substantially uniform, temporally constant main magnetic field is created along a z-axis through an examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send/receive switch 8, to a whole-body volume RF coil 9 to transmit RF pulses into the examination volume. A typical MR imaging sequence is composed of a packet of RF pulse segments of short duration which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the whole-body volume RF coil 9.

For generation of MR images of limited regions of the body 10, a set of local array RF coils 11, 12, 13 are placed contiguous to the region selected for imaging. The array coils 11, 12, 13 can be used to receive MR signals induced by body-coil RF transmissions. The resultant MR signals are picked up by the whole body volume RF coil 9 and/or by the array RF coils 11, 12, 13 and demodulated by a receiver 14 preferably including a preamplifier (not shown). The receiver 14 is connected to the RF coils 9, 11, 12 and 13 via send/receive switch 8.

A host computer 15 controls the gradient pulse amplifier 3 and the transmitter 7 to generate any of a plurality of MR imaging sequences, such as diffusion-weighted TSE imaging or the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modern MR apparatuses, the data acquisition system 16 is a separate computer which is specialized in acquisition of raw image data.

Ultimately, the digital raw image data is reconstructed into an image representation by a reconstruction processor 17 which applies a Fourier transform or other appropriate reconstruction algorithms, such as SENSE or SMASH. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

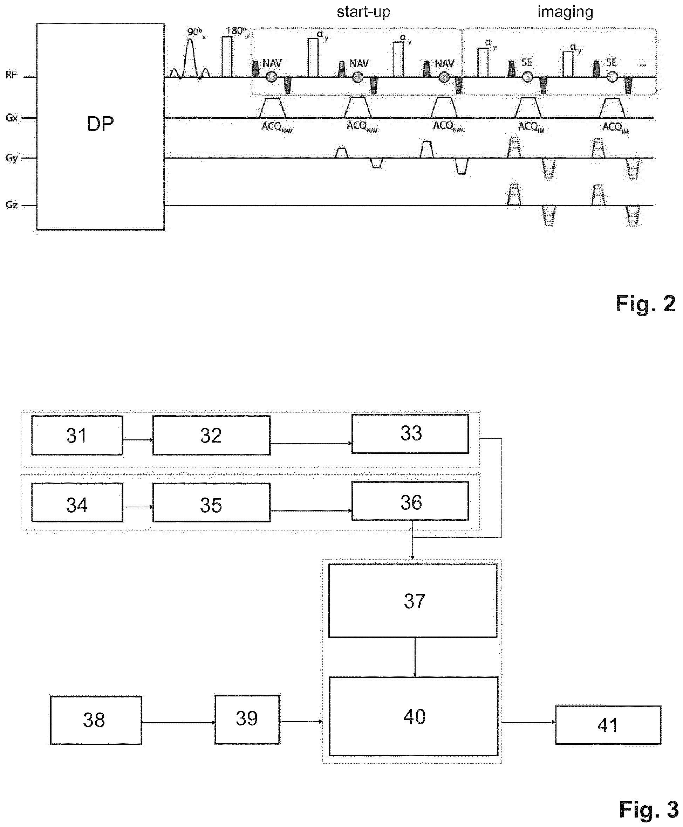

With continuing reference to Fig. 1 and with further reference to Figs. 2, 3, and 4 embodiments of the method of the invention are explained in the following.

The body 10 is subjected to multiple shots of a TSE imaging sequence as illustrated in Fig. 2. The imaging sequence is a 3D TSE sequence comprising a diffusion-preparation section DP followed by a 90° RF pulse, an initial 180° refocusing RF pulse and further refocusing RF pulses $\alpha_y$. A train of echo signals is generated comprising, in a start-up phase, a number of start-up echo signals NAV and, in an imaging phase temporally immediately subsequent to the start-up phase, a number of imaging echo signals SE. The start-up echo signals are acquired in the presence of readout magnetic field gradients $ACQ_{NAV}$ while the imaging echo signals are acquired in the presence of readout magnetic field gradients $ACQ_{IM}$. The start-up echo signals NAV are thus attributed to the start-up phase of the depicted TSE sequence in which the echo train is allowed to stabilize and to reach a steady state of the transverse nuclear magnetization. The start-up echo signals would normally not be used for image reconstruction because of the strong fluctuations of the signal amplitude which would cause undesirable image artifacts. However, it is the insight of the invention that the start-up echo signals can be used advantageously to acquire low-resolution navigator images for the estimation of motion-induced phase errors. These are used according to the invention for motion-correction in the step of reconstructing a high-resolution diffusion-weighted MR image from the imaging echo signal data. Each echo signal NAV, SE, by its respective frequency and phase encoding, represents a k-space profile. Fig. 2 shows one shot of the imaging sequence. A number of two or more of such shots are applied to acquire a full diffusion-weighted MR image. As can be seen in Fig. 2, phase-encoding is applied in both the $G_y$ and the $G_z$ directions. Hence, in the depicted embodiment, three-dimensional diffusion-weighted multi-shot TSE imaging is performed to achieve high image quality and to measure diffusion properties at high precision.

Fig. 3 shows a flow chart illustrating the phase error estimation and correction approach of the invention in the case of a three-dimensional Cartesian sampling of k-space. In step 31, start-up echo signals $knav(k_x, k_y, 0)$ are acquired without diffusion-weighting (b=0). In step 32, low-resolution k-space navigator data $knav_{lr}(k_x, k_y, 0)$ are computed from the acquired start-up echo signals and, in step 33, a low resolution reference navigator image $ref_{lr}(x, y, 0)$ is computed by fast Fourier transformation in the $k_x$, $k_y$-directions. In step 34, start-up echo signals $knav(k_x, k_y, 0)$ are acquired again, but this time with diffusion-weighting. In step 35, low-resolution k-space navigator data $knav_{lr}(k_x, k_y, 0)$ are computed from the acquired diffusion-weighted start-up echo signals and, in step 36, a low resolution navigator image $nav_{lr}(x, y, 0)$ is computed by Fourier transformation in the $k_x$, $k_y$-directions. Phase errors are then derived in step 37 for each voxel of the low-resolution navigator images $ref_{lr}(x, y, 0)$ and $nav_{lr}(x, y, 0)$ as

$$\Delta\Phi(x, y) = \text{angle}(nav_{lr}(x, y, 0)/ref_{lr}(x, y, 0)).$$

In step 38, the imaging echo signals $kim(k_x, k_y, k_z)$ are acquired within a single shot for each $k_z$ slice. This data is reconstructed by Fourier transformation in step 39 to hybrid image space data $im(x, y, k_z)$ which is motion-compensated in step 40 by phase-correcting according to the phase errors derived in step 37:

$$im_{corr}(x, y, kz) = im(x, y, kz)\, exp\,(-i\,\Delta\Phi(x, y))$$

Finally, in step 41, all images $im_{corr}(x, y, k_z)$ corrected in this fashion are combined and Fourier transformed in the $k_z$-direction to obtain the final phase-corrected three-dimensional diffusion weighted MR image $im_{corr}(x, y, z)$. In this embodiment, two-dimensional navigator images $ref_{lr}(x, y, 0)$, $nav_{lr}(x, y, 0)$ are derived from the startup echo signals and used for motion-compensation of the three-dimensional imaging data. It would equally be possible to employ three-dimensional navigator images for phase-correcting the imaging data. In this case, a correspondingly larger number of startup echo signals would have to be acquired.

In case the employed k-space trajectory is arbitrary, the estimated phase errors can be incorporated into an imaging equation for each shot as follows

$$\mathbf{d}^{(k)} = \mathbf{F}^{(k)}\mathbf{P}_e^{(k)}\mathbf{m} \, ,$$

wherein $\mathbf{d}^{(k)}$ represents the k-space data acquired with the $k^{th}$ shot and is a vector of length $L^{(k)}$, $\mathbf{F}^{(k)}$ is an $L^{(k)}$x$N$ matrix that represents the Fourier transform, $\mathbf{P}_e^{(k)}$ is an $N$x$N$ diagonal matrix with entries equal to the phase errors estimated from the navigator data of the $k^{th}$ shot, and $\mathbf{m}$ represents the phase error-free MR image and is a vector of length $N$. If the total number of shots is $N_k$, the imaging equation for all shots is

$$\begin{bmatrix} \mathbf{d}^{(0)} \\ \vdots \\ \mathbf{d}^{(N_k-1)} \end{bmatrix} = \begin{bmatrix} \mathbf{F}^{(0)} \\ \vdots \\ \mathbf{F}^{(N_k-1)} \end{bmatrix} \begin{bmatrix} \mathbf{P}_e^{(0)} \\ \vdots \\ \mathbf{P}_e^{(N_k-1)} \end{bmatrix} \mathbf{m}$$

or in short

$$\mathbf{d} = \mathbf{FPm} \quad .$$

The final phase error-free MR image can be reconstructed from this equation by solving the minimization problem

$$\mathbf{m}^* = \min_{\mathbf{m}} \|\mathbf{d} - \mathbf{FPm}\|_2^2 \quad .$$

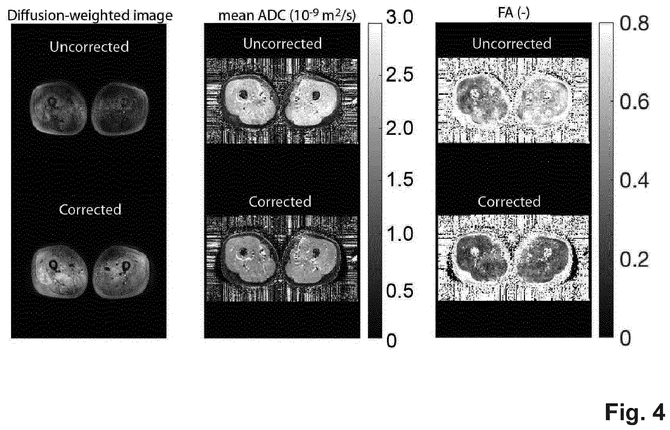

An application of the invention is shown in Fig. 4 in the context of three-dimensional TSE multi-shot diffusion tensor imaging of the human thighs. Fig. 4 shows diffusion-weighted images (left), ADC (apparent diffusion coefficient) maps (middle), and FA (fractional anisotropy) maps obtained with and without the proposed phase error estimation and correction scheme. As can be seen from the images, the motion-induced phase errors result in corrupted diffusion-weighted images and incorrect ADC and FA maps (upper line of images). By employing the proposed phase error estimation and correction, the corrupted diffusion-weighted image is restored and reasonable ADC as well as FA maps are obtained (lower line of images).

## Claims

1. Method of MR imaging of an object (10) placed in an examination volume of a MR apparatus (1), the method comprising the steps of:

    subjecting the object (10) to a number of shots of a diffusion-weighted turbo spin echo imaging sequence, a train of echo signals being generated by each shot, wherein the train of echo signals comprises a number of start-up echo signals (NAV) and a number of imaging echo signals (SE) generated temporally subsequent to the start-up echo signals (NAV);
    acquiring the start-up echo signals (NAV);
    acquiring the imaging echo signals (SE);
    deriving motion-induced phase errors from the start-up echo signals (NAV); and
    reconstructing a diffusion weighted MR image from the imaging echo signals, wherein a motion-compensation is applied by phase-correcting the MR image according to the motion-induced phase errors.

2. Method of claim 1, wherein the echo signals generated in each shot of the imaging sequence until the nuclear magnetization reaches a steady state are identified as start-up echo signals (NAV).

3. Method of claim 1 or 2, wherein a two-dimensional slice of k-space is sampled by the number of shots of the imaging sequence.

4. Method of claim 1 or 2, wherein a three-dimensional volume of k-space is sampled by the number of shots of the imaging sequence.

5. Method of claim 4, wherein a two-dimensional slice of k-space is sampled by each shot of the imaging sequence, wherein the three-dimensional volume of k-space comprises a number of subsequently sampled parallel k-space slices.

6. Method of any one of claims 1-5, wherein the motion-induced phase errors are derived by comparing start-up echo signals (NAV) acquired with and without diffusion weighting.

7. Method of any one of claims 1-6, wherein the motion-induced phase errors are derived as a phase map from a low-resolution navigator image reconstructed from the start-up echo signals (NAV).

8. MR apparatus including at least one main magnet coil (2) for generating a uniform, static magnetic field within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control unit (15) for controlling the temporal succession of RF pulses and switched magnetic field gradients, and a reconstruction unit (17), wherein the MR apparatus (1) is arranged to perform the following steps:

subjecting the object (10) to a number of shots of a diffusion-weighted turbo spin echo imaging sequence, a train of echo signals being generated by each shot, wherein the train of echo signals comprises a number of start-up echo signals (NAV) and a number of imaging echo signals (SE) generated temporally subsequent to the start-up echo signals (NAV);
acquiring the start-up echo signals (NAV);
acquiring the imaging echo signals (SE);
deriving motion-induced phase errors from the start-up echo signals (NAV); and
reconstructing a diffusion weighted MR image from the imaging echo signals, wherein a motion-compensation is applied by phase-correcting the MR image according to the motion-induced phase errors.

9. Computer program to be run on an MR apparatus (1), which computer program comprises instructions for:

producing a number of shots of a diffusion-weighted turbo spin echo imaging sequence, a train of echo signals being generated by each shot, wherein the train of echo signals comprises a number of start-up echo signals (NAV) and a number of imaging echo signals (SE) generated temporally subsequent to the start-up echo signals (NAV);
acquiring the start-up echo signals (NAV);
acquiring the imaging echo signals (SE);
deriving motion-induced phase errors from the start-up echo signals (NAV); and
reconstructing a diffusion weighted MR image from the imaging echo signals (SE), wherein a motion-compensation is applied by phase-correcting the MR image according to the motion-induced phase errors.

Fig. 1

**Fig. 2**

**Fig. 3**

Fig. 4

Europäisches
Patentamt

European
Patent Office

Office européen
des brevets

**EUROPEAN SEARCH REPORT**

Application Number

EP 17 19 9993

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CERVANTES B ET AL.: "One-Dimensional Phase Navigation of Diffusion-Weighted 3D TSE for High Resolution Musculoskeletal Diffusion Imaging", PROCEEDINGS OF THE INTERNATIONAL SOCIETY FOR MAGNETIC RESONANCE IN MEDICINE, 25ND ANNUAL MEETING AND EXHIBITION, HONOLULU, HI, USA, 22-27 APRIL 2017, vol. 25, 7 April 2017 (2017-04-07), page 3935, XP040691503, * page 1, paragraph 2 - page 2, paragraph 1; figures 1, 2 * ----- | 1,3-9 | INV. G01R33/561 G01R33/563 G01R33/565 G01R33/567 |
| X | BROCKSTEDT S ET AL: "QUANTITATIVE DIFFUSION COEFFICIENT MAPS USING FAST SPIN-ECHO MRI", MAGNETIC RESONANCE IN MEDICINE, JOHN WILEY & SONS, INC, US, vol. 16, no. 8, 1 January 1998 (1998-01-01), pages 877-886, XP000878655, ISSN: 0740-3194 * page 878 - page 880; figure 1 * ----- | 1,3-5, 7-9 | |
| X | VON MENGERSHAUSEN M ET AL: "3D diffusion tensor imaging with 2D navigated turbo spin echo", MAGNETIC RESONANCE MATERIALS IN PHYSICS, BIOLOGY AND MEDICINE, CHAPMAN AND HALL, LONDON, GB, vol. 18, no. 4, 9 September 2005 (2005-09-09), pages 206-216, XP019358214, ISSN: 1352-8661 * page 207, column 2, paragraph 2 - page 211, column 1, paragraph 1; figure 1 * ----- -/-- | 1,3-6,8, 9 | |

**TECHNICAL FIELDS SEARCHED (IPC)**

G01R

The present search report has been drawn up for all claims

| Place of search | Date of completion of the search | Examiner |
|---|---|---|
| Munich | 27 April 2018 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 17 19 9993

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | QINWEI ZHANG ET AL: "Diffusion-prepared stimulated-echo turbo spin echo (DPsti-TSE): An eddy current-insensitive sequence for three-dimensional high-resolution and undistorted diffusion-weighted imaging", NMR IN BIOMEDICINE., vol. 30, no. 7, 13 March 2017 (2017-03-13), page e3719, XP055455294, GB ISSN: 0952-3480, DOI: 10.1002/nbm.3719 * the whole document * | 1-9 | |
| A | MORI S ET AL: "A MOTION CORRECTION SCHEME BY TWIN-ECHO NAVIGATION FOR DIFFUSION-WEIGHTED MAGNETIC RESONANCE IMAGING WITH MULTIPLE RF ECHO ACQUISITION", MAGNETIC RESONANCE IN MEDICINE, JOHN WILEY & SONS, INC, US, vol. 40, no. 4, 1 October 1998 (1998-10-01), pages 511-516, XP000878657, ISSN: 0740-3194 * the whole document * | 1-9 | |

TECHNICAL FIELDS
SEARCHED (IPC)

The present search report has been drawn up for all claims

| Place of search | Date of completion of the search | Examiner |
|---|---|---|
| Munich | 27 April 2018 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **ZHANG et al.** Diffusion-prepared stimulated-echo turbo spin echo (DPsti-TSE): An eddy current-insensitive sequence for three-dimensional high-resolution and undistorted diffusion-weighted imaging. *NMR in biomedicine,* 2017
- **CERVANTES et al.** High-resolution DTI of distal peripheral nerves using flow-compensated diffusion-prepared 3D TSE. *Proc. Intl. Soc. Mag. Reson. Med.,* 2016, vol. 24, 4530
- **XIE et al.** High resolution 3D diffusion cardiovascular magnetic resonance of carotid vessel wall to detect lipid core without contrast media. *J. Cardiovasc. Magn. Reson.,* 2014, vol. 16, 67
- **ZHANG et al.** High resolution 3D diffusion imaging of carotid vessel wall using stimulated echo based diffusion prepared turbo spin echo sequence. *Proc. Intl. Soc. Mag. Reson. Med.,* 2016, vol. 24, 959